# EUROPÄISCHE PATENTSCHRIFT

(11) **EP 3 602 774 B1**
(45) Veröffentlichungstag und Bekanntmachung des Hinweises auf die Patenterteilung: **24.03.2021**
(21) Anmeldenummer: 18723766.4
(22) Anmeldetag: 02.05.2018
(51) Int. Cl.: H02P 29/024, G01R 31/327, H02H 11/00, H02H 3/44

(54) **DIAGNOSEFÄHIGER SANFTSTARTER, DIAGNOSEVERFAHREN UND MOTORANORDNUNG**
DIAGNOSABLE SOFT STARTER, DIAGNOSTIC METHOD, AND MOTOR ARRANGEMENT
DÉMARREUR PROGRESSIF À CAPACITÉ DE DIAGNOSTIC, PROCÉDÉ DE DIAGNOSTIC ET ENSEMBLE MOTEUR

(30) Priorität: 22.05.2017 DE 102017208648
(43) Veröffentlichungstag der Anmeldung: 05.02.2020
(73) Patentinhaber: Siemens Aktiengesellschaft, 80333 München (DE)
(72) Erfinder: HERTZ, Dirk, 92260 Fichtenhof (DE); SEITZ, Johann, 92224 Amberg (DE)
(86) Internationale Anmeldenummer: PCT/EP2018/061105
(87) Internationale Veröffentlichungsnummer: WO 2018/215175

(56) Entgegenhaltungen:
- EP-A1- 1 203 434
- EP-A2- 1 744 169
- CN-A- 103 063 978
- DE-A1-102013 209 509
- JP-A- H06 311 783

## Beschreibung

Die Erfindung betrifft einen Motoranordnung umfassend einen diagnosefähigen Sanftstarter und eine Diagnoseverfahren zur Erkennung einer defekten Komponente in einem Sanftstarter. Die Erfindung betrifft auch ein Computerprogrammprodukt, durch das das erfindungsgemäße Diagnoseverfahren in einem Sanftstarter umgesetzt wird.

Aus EP2017868A1 (Phoenix Contact GmbH & Co. KG) 21.01.2009 ist eine dreiphasige Leistungsendstufe bekannt, in der in den jeweiligen Phasen Thyristorenpaare und parallele Schaltkontakte angeordnet sind. Zwischen den Phasen ist ein Spannungsdetektor angeschlossen, der pro Phase mehrere Widerstände aufweist. Die Mehrzahl an Widerständen bildet Spannungsteiler und wirkt mit Stromdetektoren in den einzelnen Phasen zusammen. Die Spannungsteiler und die Stromdetektoren dienen dabei zur Fehlererkennung in der Leistungsendstufe.

Aus US2122107 (L. J. Meller et al.) 28.06.1938 ist eine Mehrzahl an Reaktanzen bekannt, die induktiv, kapazitativ oder als ohmsche Widerstände ausgebildet sind. Die Reaktanzen sind miteinander verbunden und an einem Ende mit einer Relaisspule verbunden. Die Relaisspule ist am entgegengesetzten Ende wiederum mit einem Sternpunkt eines Elektromotors verbunden.

DE102014223856A1 (Siemens AG) 25.05.2016 beschreibt eine Schaltungsanordnung zur Ansteuerung eines dreiphasigen Elektromotors, mit einer oder mehreren Schmelzsicherungen, die in einer jeweiligen Phase zwischen zugeordneten Netzanschlüssen und dem Elektromotor angeordnet sind, und mit einem Sanftstarter, welcher zwischen dem Elektromotor und den Schmelzsicherungen angeordnet ist. Dabei sind ein Überwachungsmittel zur Überwachung der Schaltungsanordnung auf das Vorliegen eines Fehlers und ein oder mehrere, steuerbare Schaltelemente vorgesehen, wobei ein jeweiliges Schaltelement zwischen einer Phase und einer anderen Phase oder einem Rückleiter verschaltet ist, wobei das Überwachungsmittel bei einem detektieren Fehler zumindest eines der Schaltelemente leitend schaltet, um ein Auslösen der Schmelzsicherungen zu erzwingen.

EP1203434A1 (York Int. Corp.) 08.05.2002 beschreibt eine Vorrichtung zur Erkennung eines defekten gesperrten Thyristors in einer Halbleiter-Steuerung zur Stromversorgung eines Verbrauchers im herabgesteuerten Betrieb. Die Vorrichtung umfasst einen Spannungsmesser zur Ermittlung der Spannung am Thyristor. Die Vorrichtung umfasst außerdem Mittel zur Meldung eines defekten gesperrten Thyristors, falls der absolute Wert der Spannung am Thyristor innerhalb eines vorgegebenen Zeitbereichs unterhalb eines Grenzwerts bleibt.

DE102013209509A1 (Hitachi Automotive Systems Ltd.) 28.11.2013 beschreibt eine Steuervorrichtung mit einem Wechselrichter. Die Steuervorrichtung steuert die elektrische Leistung, die einem Motor zugeführt werden soll, und umfasst Ausgangsleitungen, die Ausgaben von dem Wechselrichter zum Motor liefern. Dabei wird eine Bestimmung hinsichtlich dessen, ob eine Anomalität in den Ausgangsleitungen auftritt, auf der Basis einer tatsächlichen Neutralpunktspannung des Motors, die sich schrittweise in Übereinstimmung mit einem durch den Wechselrichter ausgegebenen PWM-Impulsmuster ändert, und einer normalen Neutralpunktspannung, die von einem von dem Wechselrichter ausgegebenen PWM-Muster abhängt, durchgeführt. Auf diese Weise kann aus einer normalen Neutralpunktspannung, die von einem PWM-Impulsmuster (Ausgangsspannungsvektor) gemäß modulierten Wellen abhängt, und einer tatsächlichen Neutralpunktspannung, die von einem PWM-Impulsmuster abhängt, bestimmt werden, ob eine Anomalität wie z. B. ein Kurzschluss gegen die Erdung oder ein Kurzschluss gegen die Versorgung in den Ausgangsleitungen auftritt.

Ferner sind Motoranordnungen bekannt, die Sanftstarter und mindestens ein nachgeschaltetes Schütz umfassen. Derartige Motoranordnungen erfordern zur Gewährleistung eines SIL-Levels von 1 mindestens ein dem Sanftstarter nachgeschaltetes Schütz. Zusätzlich ist ein Sicherheitsschaltgerät erforderlich. Für ein SIL-Level von 3 sind in den bekannten Motoranordnungen wiederum mindestens zwei Schütze und ein Sicherheitsschaltgerät erforderlich. Derartige Motoranordnungen können beispielsweise basierend auf dem Sicherheitsschaltgerät 3SK1 und dem Sanftstarter 3RW4 der Siemens AG zusammengestellt werden.

In der Automatisierungstechnik besteht Bedarf an Geräten zur Betätigung von Elektromotoren, die ein hohes Maß an Sicherheit bereitstellen und dabei gleichzeitig einfach, kompakt und kosteneffizient sind. Insbesondere wird angestrebt, Motoranordnungen mit erhöhter oder zumindest gleichbleibender Sicherheit bei reduziertem Hardware- und Montageaufwand bereitzustellen.

Der Erfindung liegt die Aufgabenstellung zugrunde, eine Motoranordnung zur Verfügung zu stellen, die die bekannten Lösungen in den beschriebenen Punkten verbessert.

Die vorliegende Erfindung ist in den unabhängigen Ansprüchen definiert, wobei bevorzugte Ausführungsformen in den abhängigen Ansprüchen offenbart sind.

Die skizzierte Aufgabenstellung wird durch einen Sanftstarter für die Automatisierungstechnik gelöst, der über eine Mehrzahl an Phasen auf einer netzzugewandten Seite mit einer Stromversorgung verbindbar ist. Der Sanftstarter weist in jeder der Phasen ein Halbleiterschaltelement auf, zu dem parallel ein elektromechanischer Schalter angeordnet ist. Das Halbleiterschaltelement und der elektromechanische Schalter in den Phasen sind dazu ausgebildet, durch koordinierte Betätigung einen Stromfluss durch die jeweilige Phase zu erlauben oder zu verhindern. Auf einer lastzugewandten Seite der Halbleiterschaltelemente und der elektromechanischen Schalter ist der Sanftstarter mit einem Elektromotor, verbindbar. Erfindungsgemäß ist in dem Sanftstarter auf der lastzugewandten Seite der Halbleiterschaltelemente und der elektromechanischen Schalter zwischen den Phasen eine sternpunktbildende Schaltung ausgebildet, welche Leitungen aufweist, die in einem Sternpunkt verbunden sind. Alternativ können die Leitungen auch zu einer Dreieckschaltung verbunden werden. Die sternpunktbildende Schaltung weist dabei mindestens eine passive Komponente auf, die jeweils in den Leitungen der Sternpunktschaltung angeordnet sind. Unter einer passiven Komponente ist beispielsweise ein Widerstand oder ein Kondensator zu verstehen. Bei einem Defekt eines Halbleiterschalterelements oder eines elektromechanischen Schalters in einer ersten Phase tritt im Halbleiterschaltelement der ersten Phase durch die sternpunktbildende Schaltung ein reduzierter Spannungsabfall auf. Der reduzierte Spannungsabfall durch die sternpunktbildende Schaltung ist durch ein Spannungsmessmittel erfassbar, das parallel zu einem Halbleiterschaltelement in der ersten Phase angeordnet ist. Der Spannungsabfall ist bei Vorliegen eines Defekts gegenüber einem Spannungsabfall in einem defektfreien Zustand reduziert. Das Spannungsmessmittel in der ersten Phase erfasst dabei einen Spannungsabfall über dem Halbleiterschaltelement. Anhand des Spannungsabfalls ist ein Defekt eines Halbleiterschalterelements und/oder eines elektromechanischen Schalters in der ersten Phase im Sanftstarter erkennbar. Durch die sternpunktbildende Schaltung wird eine Diagnosefunktion auf defekte Halbleiterschaltelemente und/oder defekte elektromechanische Schalter gewährleistet. Die so verwirklichte Diagnosefunktion basiert dabei mit der sternpunktbildenden Schaltung, die vorzugsweise ausschließlich passive Komponenten aufweist, und dem geeigneten Spannungsmessmittel auf einem Minimum an Bauteilen und ist dadurch kompakt und kosteneffizient herstellbar. Die Diagnosefunktion ist auch dann durchführbar, wenn die angeschlossene elektrische Last, der Elektromotor, abgeschaltet ist. Die sternpunktbildende Schaltung auf der lastzugewandten Seite der Halbleiterschaltelemente und der elektromechanischen Schalter des Sanftstarters bietet ein hohes Maß an Zuverlässigkeit und stellt dem Sanftstarter eine Möglichkeit zur Verfügung, einen Eigendefekt schnell zu erkennen. Mit dem Sanftstarter ist daher bereits ohne zusätzliche Komponenten, wie beispielsweise Schütze, ein SIL-Level von 1 erzielbar. In Motoranordnungen kann bei Einsatz des Sanftstarters auf ein Schütz verzichtet werden, ohne die Sicherheit der gesamten Motoranordnung zu beeinträchtigen.

In einer bevorzugten Ausführungsform ist die mindestens eine passive Komponente in der Sternpunktschaltung als Widerstand mit 10 kΩ bis 500 kΩ ausgebildet. Ein Widerstand in diesem Wertebereich begrenzt die Verlustleistung in der sternpunktbildenden Schaltung auf ein erträgliches Maß. Gleichzeitig erlaubt ein Widerstand in diesem Wertebereich einen Spannungsabfall an den Halbleiterschaltelementen, der für eine zuverlässige Erfassung ausreichend hoch ist.

Weiter bevorzugt ist in jeder der Phasen, insbesondere bei drei Phasen, in jeder der Leitungen der sternpunktbildenden Schaltung ein Widerstand angeordnet. Die Widerstände in den Leitungen der Sternpunktschaltung weisen besonders bevorzugt gleich hohe Widerstandswerte auf. Dies gewährleistet eine gleichmäßige Verteilung der Spannung an den intakten Halbleiterschaltelementen, wenn ein defektes Halbleiterschaltelement und/oder ein defekter elektromechanischer Schalter erkannt werden. Darüber hinaus gewährleisten Widerstände mit gleichen Widerstandswerten in jeder Phase einen stabilen Dauerbetrieb des Sanftstarters und eine gleichmäßige Verteilung der anfallenden Verlustleistung.

Des Weiteren kann im Sanftstarter das Spannungsmessmittel mit einer Steuereinheit verbunden sein. Durch die Verbindung sind Messdaten an die Steuereinheit übertragbar. Die Steuereinheit ist dazu ausgebildet, Betätigungsbefehle an die Halbleiterschalterelemente und/oder die elektromechanischen Schalter zu senden, diese also zu öffnen oder zu schließen. Ferner weist die Steuereinheit einen Speicher und ein Rechenwerk zur Speicherung und Ausführung eines Computerprogrammprodukts geeignet, mit dem der Betrieb des Sanftstarters umsetzbar ist. Durch die Steuereinheit ist prüfbar, ob der erfasste reduzierte Spannungsabfall in der Sternpunktschaltung einen einstellbaren Schwellenwert unterschreitet, wodurch ein Defekt eines Halbleiterschaltelements und/oder elektromechanischen Schalter identifizierbar ist. Ebenso erlaubt die Steuereinheit, nach dem Erkennen eines solchen Defekts das aktive Einleiten von Gegenmaßnahmen, beispielsweise das Unterdrücken von Betätigungsbefehlen, die ein Schließen der intakten Halbleiterschaltelemente und/oder elektromechanischen Schalter vorgeben.

Die Steuereinheit des Sanftstarters ist vorzugsweise als interne Steuereinheit ausgebildet, die beispielsweise in Form eines Mikrocontrollers im Sanftstarter angeordnet ist. Alternativ kann die Steuereinheit auch als übergeordnete Steuereinheit ausgebildet sein. Dies kann unter anderem ein Sicherheitsschaltgerät ein Parametriergerät, eine Speicherprogrammierbare Steuerung, kurz: SPS, oder eine Cloud sein. Weiter alternativ können die Funktionen der Steuereinheit auch auf eine interne und eine übergeordnete Steuereinheit aufgeteilt sein, die zum Betrieb des Sanftstarters zusammenwirken.

Der Sanftstarter weist in jeder der Phasen ein Spannungsmessmittel auf. Die Spannungsmessmittel sind jeweils derart in der mindestens einen Phase angeordnet, dass ein Spannungsabfall über dem jeweiligen Halbleiterschaltelement und den zugehörigen elektromechanischen Schalter erfassbar ist. Bei einem defekten Halbleiterschaltelement und/oder einem defekten elektromechanischen Schalter liegt daran durch die sternpunktbildende Schaltung ein geringerer Spannungsabfall vor als an einem intakten sperrenden Halbleiterschaltelement mit dem zugehörigen parallelen geöffneten elektromechanischen Schalter. Dadurch wird die Erkennung von defekten Halbleiterschaltelementen und/oder defekten elektromechanischen Schalter auch dann ermöglicht, wenn die lastseitigen Anschlüsse offen bzw. ein nachgeschaltetes Schaltgerät, ein Schütz, geöffnet ist. Dies gewährleistet eine differenzierte Identifikation des eingetretenen Defekts und die Erreichung eines erhöhten SIL-Levels.

In einem nicht erfindungsgemäßen Beispiel, weist eine einen SIL-Level von 1 auf und erfüllt damit eine anwendungsspezifische Sicherheitsanforderung. Die Motoranordnung umfasst einen Elektromotor, der unmittelbar mit einem Sanftstarter verbunden ist. Der Sanftstarter wiederum ist mit einer Stromversorgung mit mehreren Phasen verbunden. Der Sanftstarter ist dabei gemäß einer der oben skizzierten Ausführungsformen ausgebildet. Die Motoranordnung ist frei von zusätzlichen Schützen und bietet ein hohes Maß an Sicherheit. Insbesondere wird das Sicherheits-Integritäts-level 1, kurz SIL 1, erreicht. Die Motoranordnung bietet folglich im Vergleich zu den bekannten Lösungen eine entsprechend hohe Sicherheit bei reduziertem Aufwand an Komponenten. Die Motoranordnung ist also schnell, einfach und kosteneffizient herstellbar.

Die zugrundeliegende Aufgabenstellung wird von einer erfindungsgemäßen Motoranordnung gelöst. Die Motoranordnung weist ein SIL-Level von 3 auf und ist damit für sicherheitskritische Anwendungen geeignet. Die Motoranordnung umfasst einen Elektromotor, der über mehrere Phasen mit Strom versorgt wird. Die Motoranordnung ist folglich auch mit einer entsprechenden mehrphasigen Stromversorgung gekoppelt. Dem Elektromotor ist ein Schütz vorgeschaltet, dem wiederum ein Sanftstarter vorgeschaltet ist. Der Sanftstarter wiederum ist mit der mehrphasigen Stromversorgung verbunden. Also gelangt die für den Betrieb des Elektromotors benötigte elektrische Energie aus der mehrphasigen Stromversorgung über den Sanftstarter und das dem Sanftstarter nachgeschaltete Schütz zu dem Elektromotor. Erfindungsgemäß ist der Sanftstarter gemäß einer der oben skizzierten Ausführungsformen ausgebildet. Die erfindungsgemäße Motoranordnung bietet folglich mit nur einem Schütz ein SIL-Level von 3. Gegenüber den bekannten Lösungen mit zwei Schützen stellt dies eine Reduzierung im Hardwareaufwand dar. Die erfindungsgemäße Motoranordnung erreicht insgesamt ein Sicherheits-Integritätslevel, kurz SIL, von 3 bei reduzierter Komponentenanzahl. Hierdurch ist die erfindungsgemäße Motoranordnung einfach, schnell und kosteneffizient herstellbar.

Die beschriebene Aufgabenstellung wird auch durch das erfindungsgemäße Diagnoseverfahren gelöst.

Erfindungsgemäß, kommt das Diagnoseverfahren zur Anwendung in folgender Motoranordnung: Die Motoranordnung umfasst einen eine Last bildenden mehrphasigen Elektromotor, der über mehrere Phasen aus einer mehrphasigen Stromversorgung mit Strom versorgt wird. Dem Elektromotor ist ein Schaltgerät, z. B. ein Schütz, vorgeschaltet, dem wiederum ein Sanftstarter vorgeschaltet ist. Der Sanftstarter wiederum ist mit der mehrphasigen Stromversorgung verbunden. Also gelangt die für den Betrieb des Elektromotors benötigte elektrische Energie aus der mehrphasigen Stromversorgung über den Sanftstarter und das dem Sanftstarter nachgeschaltete Schaltgerät zu dem Elektromotor. Im Sanftstarter sind in jeder Phase ein Halbleiterschaltelement und ein parallel geschalteter elektromechanischer Schalter angebracht. In dem Sanftstarter sind auf einer lastzugewandten Seite der Halbleiterschaltelemente und der elektromechanischen Schalter die Phasen in einer sternpunktbildenden Schaltung verbunden, wobei die sternpunktbildende Schaltung mindestens eine passive Komponente umfasst. Dabei dient die sternpunktbildende Schaltung zur Erfassung eines Spannungsabfalls in einem defekten Zustand eines Halbleiterschaltelements und/oder eines elektromechanischen Schalters mithilfe des Diagnoseverfahrens. Dazu wird in einem ersten Schritt durch eine Steuereinheit ein Betätigungsbefehl ausgegeben, durch den eine Öffnung der Halbleiterschaltelemente und der elektromechanischen Schalter vorgegeben wird. In einem bestimmungsgemäßen, also defektfreien, Zustand des Sanftstarters wird so der Stromfluss in allen Phasen unterbrochen. In einem weiteren Schritt wird durch die Steuereinheit ein Betätigungsbefehl ausgegeben, durch den eine Öffnung von Kontakten des Schaltgeräts, mit dem die stromführenden Phasen geschaltet werden, vorgegeben wird. Das Schaltgerät wird also in einen Zustand mit geöffneten Kontakten in den Phasenleitern gebracht. In einem weiteren Schritt wird ein Spannungsabfall über dem Halbleiterschaltelement und/oder dem elektromechanischen Schalter des Sanftstarters erfasst. Dabei wird auch erfasst, ob der Spannungsabfall gegenüber einem defektfreien Zustand reduziert ist. Dies erfolgt durch ein Spannungsmessmittel, das an der entsprechenden Phase angeschlossen ist. Dabei kann in der entsprechenden Phase ein defektes Halbleiterschaltelement und/oder ein defekter elektromechanischer Schalter erkannt werden, wenn der mit dem Spannungsmessmittel erfasste reduzierte Spannungsabfall einen einstellbaren Schwellenwert unterschreitet. Der einstellbare Schwellenwert ist beispielsweise in einer Steuereinheit gespeichert, mittels der das Diagnoseverfahren durchgeführt wird. Der Schwellenwert kann fest vorgegeben sein, durch einen Benutzer des Sanftstarters und/oder eine übergeordnete Steuereinheit eingestellt werden. Bei einem defekten Halbleiterschaltelement und/oder defekten elektromechanischen Schalter ist die dort mit dem Spannungsmessmittel erfassbare Spannung erheblich reduziert, wobei der einstellbare Schwellenwert ein Maß dafür ist, mit welcher Empfindlichkeit dieser Rückgang gegenüber dem bestimmungsgemäßen Zustand zu erfassen ist.

Der Sanftstarter ist niederohmiger als das nachgeschaltete Schaltgerät. Würde man nun den Spannungsabfall über dem Halbleiterschaltelement und/oder dem elektromechanischen Schalter des Sanftstarters ohne die sternpunktbildende Schaltung des Sanftstarters erfassen, so erhielte man einen undefinierten Spannungswert, hervorgerufen durch parasitäre Widerstände etc. Dieser undefinierte Spannungswert könnte nicht für eine sichere Diagnose des Sanftstarters verwendet werden. Durch die sternpunktbildende Schaltung wird also eine Diagnosefunktion auf defekte Halbleiterschaltelemente und/oder defekte elektromechanische Schalter des Sanftstarters gewährleistet. Das Diagnoseverfahren ist dabei für einen Sanftstarter ausgelegt, der über eine Mehrzahl an Phasen mit einer Stromversorgung und über ein Schaltgerät mit einem Elektromotor verbunden ist.

In einer weiteren bevorzugten Ausführungsform der Erfindung wird im Diagnoseverfahren eine Warnung ausgegeben, wenn ein defektes Halbleiterschaltelement und/oder ein defekter elektromechanischer Schalter erkannt werden. Alternativ oder ergänzend kann auch mittels der Steuereinheit, die dazu ausgebildet ist, Betätigungsbefehle an die Halbleiterschaltelemente und die elektromechanischen Schalter zu senden, eine Gegenmaßnahme durchgeführt werden, wenn eine defekte Komponente erkannt wird. Dabei wird durch die Steuereinheit mit tels einer geeigneten Programmierung jede Betätigung zum Schließen der Halbleiterschaltelemente und/oder der elektromechanischen Schalter unterbunden. Dies erfolgt beispielsweise dadurch, dass entsprechende Betätigungsbefehle, die beispielsweise von einer übergeordneten Steuereinheit gesendet werden oder durch eine Benutzereingabe hervorgerufen werden, durch die Steuereinheit unterdrückt werden. Dadurch wird eine weitere Beschädigung des Sanftstarters und/oder einer angeschlossenen Applikation, wie beispielsweise einen Elektromotor, verhindert. Zusätzlich wird das Risiko einer Gefährdung von Personen verhindert. Das erzielbare Maß an Sicherheit wird so weiter gesteigert.

Die zugrundeliegende Aufgabenstellung wird auch durch ein erfindungsgemäßes Computerprogrammprodukt gelöst. Das Computerprogrammprodukt ist zum Empfangen von Messdaten ausgebildet, die durch ein Spannungsmessmittel erzeugt und gesendet werden. Das Spannungsmessmittel ist dabei mit einem Halbleiterschaltelement und/oder einem elektromechanischen Schalter verbunden und dazu ausgebildet, einen Spannungsabfall am Halbleiterschaltelement und/oder dem elektromechanischen Schalter zu erfassen. Der Sanftstarter ist dabei an mehrere Phasen angeschlossen und weist in jeder Phase ein Halbleiterschaltelement und einen parallel geschalteten elektromechanischen Schalter auf. Das Computerprogrammprodukt ist auch dazu ausgelegt, Betätigungsbefehle, an diese Halbleiterschaltelemente und/oder die elektromechanischen Schalter zu senden. Erfindungsgemäß werden die eingehenden Messdaten vom Computerprogrammprodukt verarbeitet und in die Durchführung eines Diagnoseverfahrens eingebracht. Das so durchgeführte Diagnoseverfahren ist dabei gemäß mindestens einer der oben skizzierten Ausführungsformen des Diagnoseverfahrens ausgebildet. Das Computerprogrammprodukt ist dazu ausgelegt, in einer Steuereinheit eines Sanftstarters gemäß mindestens einer der oben beschriebenen Ausführungsformen durchgeführt zu werden. Dabei kann das Computerprogrammprodukt monolithisch, also zusammenhängend, in einer internen Steuereinheit des Sanftstarters, wie beispielsweise einem Mikrocontroller, oder einer übergeordneten Steuereinheit durchgeführt werden. Alternativ kann das Computerprogrammprodukt auch funktionell geteilt sein und einzelne Schritte oder Funktionen des durchgeführten Diagnoseverfahrens auf die interne Steuereinheit und die übergeordnete Steuereinheit verteilt sein. Das erfindungsge-mäße Computerprogrammprodukt kann als Software oder als Firmware ausgebildet sein. Alternativ oder ergänzend kann das erfindungsgemäße Computerprogrammprodukt auch festverdrahtet in Hardware, beispielsweise einer Anwendungsspezifischen integrierten Schaltung, kurz: ASIC, verwirklicht sein (ASIC = Application-Specific Integrated Circuit).

Das erfindungsgemäße Computerprogrammprodukt erlaubt bei entsprechend ausgebildeten Sanftstartern und/oder übergeordneten Steuereinheiten, über daran angebrachte gebräuchliche Mensch-Maschine-Interfaces, kurz: HMIs, eine einfache Einstellbarkeit des durchzuführenden Diagnoseverfahrens (HMI = Human Machine Interface). Dies umfasst auch zusätzliche Parameter, die die Interaktion des erfindungsgemäßen Verfahrens mit weiteren Funktionen eines Automatisierungssystems charakterisiert. Dies kann beispielsweise eine Auswahl einer Warnung sein, die nach dem Einleiten einer Gegenmaßnahme ausgegeben wird. Die Implementierung des Diagnoseverfahrens mittels eines Computerprogrammprodukts erlaubt es auch, diese bei einem bestehenden Automatisierungssystem nachzurüsten.

Die Erfindung wird im Folgenden anhand einzelner Ausführungsformen beschrieben. Es zeigt im Einzelnen:
- FIG 1: eine Ausführungsform des erfindungsgemäßen Sanftstarters;
- FIG 2: einen Ablauf einer Ausführungsform des Diagnoseverfahrens;
- FIG 3: eine Ausführungsform einer nicht erfindungsgemäßen Motoranordnung;
- FIG 4: eine Ausführungsform einer erfindungsgemäßen Motoranordnung.

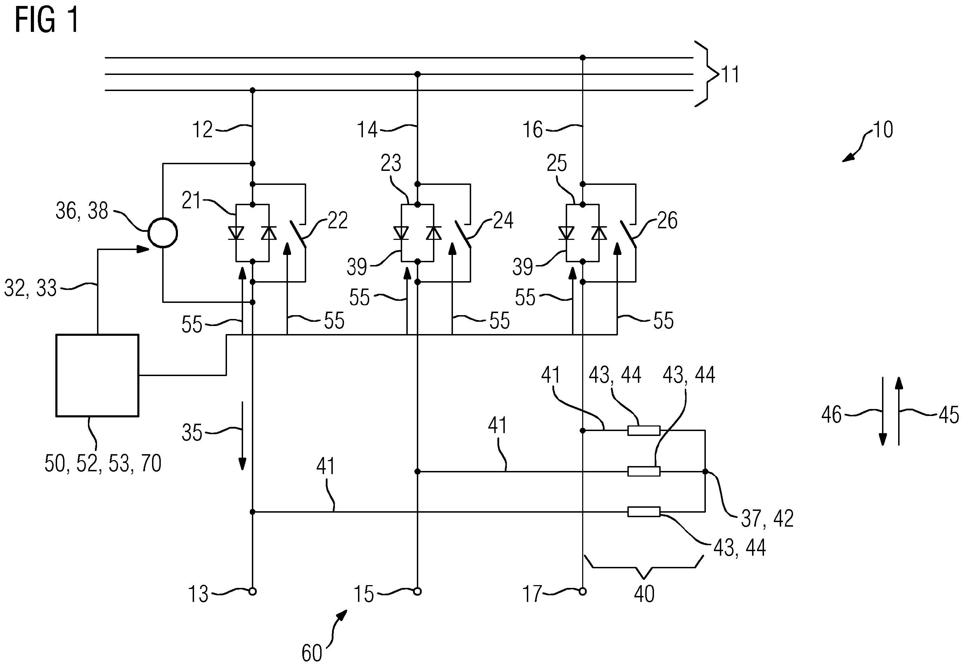

FIG 1 zeigt schematisch eine Ausführungsform des erfindungsgemäßen Sanftstarters 10. Der Sanftstarter 10 ist mit einer Stromversorgung 11 verbunden und weist drei Phasen 12, 14, 16 auf. Jede der Phasen 12, 14, 16 weist an einem lastzugewandten Ende eine Anschlussklemme 13, 15, 17 auf. Der Begriff lastzugewandt und sein Gegenstück, nämlich netzzugewandt, beziehen sich dabei auf die jeweilige Seite des Sanftstarters 10, an dem eine nicht näher dargestellte Applikation, insbesondere ein Elektromotor 60, anschließbar ist, bzw. die Seite, an der der Sanftstarter 10 mit der Stromversorgung 11 verbunden ist. Die Lage einer lastzugewandten Seite wird in FIG 1 durch den Pfeil 46 dargestellt, die Lage einer netzzugewandten Seite durch den Pfeil 45.

In jeder der Phasen 12, 14, 16 ist ein Halbleiterschaltelement 21, 23, 25 angeordnet, das dazu ausgebildet ist, unter Zusammenwirkung mit jeweils einem elektromechanischen Schalter 22, 24, 26 den Stromfluss durch die jeweilige Phase 12, 14, 16 zu unterbrechen bzw. zu ermöglichen. Die Halbleiterschaltelemente 21, 23, 25 und die elektromechanischen Schalter 22, 24, 26 werden über eine Steuereinheit 50 angesteuert, die dazu ausgebildet ist, Betätigungsbefehle 55 an die Halbleiterschaltelemente 21, 23, 25 und die elektromechanischen Schaler 22, 24, 26 zu senden. Die Steuereinheit 50 ist als interne Steuereinheit 52 ausgebildet, die baulich in den Sanftstarter 10 integriert ist. Die interne Steuereinheit 52 ist als Mikrocontroller ausgebildet, der dazu ausgebildet ist, ein Computerprogrammprodukt 70 zu speichern und auszuführen.

Auf einer lastzugewandten Seite der Halbleiterschaltelemente 21, 23, 25 und der elektromechanischen Schalter 22, 24, 26 ist eine sternpunktbildende Schaltung 40 angeordnet, die die Phasen 12, 14, 16 in einem künstlichen Sternpunkt 42 verbindet. In jeder der Leitungen 41 ist eine passive Komponente 43 angeordnet, die jeweils als Widerstand 44 ausgebildet ist. Dem Halbleiterschaltelement 21 und dem elektromechanischen Schalter 22 in einer ersten Phase 12 ist ein Spannungsmessmittel 36 zugeordnet, das zur Erfassung eines Spannungsabfalls 38 am Halbleiterschaltelement 21 und dem elektromechanischen Schalter 22 geeignet ist. Dazu ist das Spannungsmessmittel 36 mit der Steuereinheit 50 verbunden. Das Spannungsmessmittel 36 erzeugt durch seine Messzugriffe 32 Messdaten 33, die an die Steuereinheit 50 weitergeleitet werden. Die Messdaten 33 dienen als Eingabe für das Computerprogrammprodukt 70, das in der Steuereinheit 50 ausgeführt wird.

Bei einem Defekt im Halbleiterschaltelement 21 und oder dem elektronischen Schalter 22 in der ersten Phase 12, der beispielsweise durch ein Durchlegieren oder ein Kontaktverschweißen hervorrufbar ist, entsteht ein reduzierter Spannungsabfall 38 am Halbleiterschaltelement 21 und dem elektromechanischen Schalter 22 in der ersten Phase 12.

Beim Auftreten des Defekts im Halbleiterschaltelement 21 und/oder dem elektromechanischen Schalter 22 in der ersten Phase 12 ist der Spannungsabfall 38 am Halbleiterschaltelement 21 und dem elektromechanischen Schalter 22 in der ersten Phase 12 erheblich reduziert. Wenn dabei ein in der Steuereinheit 50 gespeicherter, nicht näher dargestellter Schwellenwert 53 unterschritten wird, wird dies als Vorliegen des zuvor erkannten Defekts in der ersten Phase 12 identifiziert. Bei einem Sanftstarter mit jeweils einem Spannungsmessmittel 36 in mehreren Phasen 12, 14, 16 ist folglich identifizierbar, in welcher der Phasen 12, 14 ,16 das defekte Halbleiterschaltelement 21 und/oder der defekte elektromechanische Schalter 22 vorliegen. Ferner sind bei Erkennen eines Defekts durch das Computerprogrammprodukt 70 in der Steuereinheit 50 Gegenmaßnahmen einleitbar. Dazu gehört unter anderem das Unterdrücken von Betätigungsbefehlen 55, die ein Schließen der Halbleiterschaltelemente 21, 23, 25 und/oder der elektromechanischen Schalter 22, 24, 26 vorgeben.

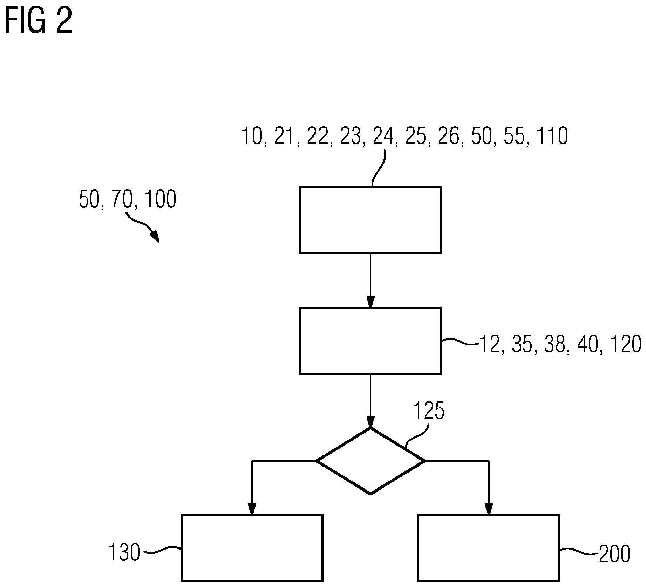

Die FIG 2 zeigt schematisch den Ablauf einer Ausführungsform des erfindungsgemäßen Diagnoseverfahrens 100 zur Erkennung eines defekten Halbleiterschaltelements 21, 23, 25 und/oder elektromechanischen Schalters 22, 24, 26 in einem nicht näher dargestellten Sanftstarter 10. Das Diagnoseverfahren 100 umfasst einen ersten Verfahrensschritt 110, in dem durch eine Steuereinheit 50 ein Betätigungsbefehl 55 zum Öffnen der Halbleiterschaltelemente 21, 23, 25 und der elektromechanischen Schalter 22, 24, 26 ausgegeben wird. Hierdurch wird in den Phasen mit intakten Halbleiterschaltelementen 21, 23, 25 und intakten elektromechanischen Schaltern 22, 24, 26 der Stromfluss unterbrochen.

In einem zweiten Verfahrensschritt 120 erfolgt ein Erfassen eines Spannungsabfalls 38 über dem Halbleiterschaltelement 21 und dem elektromechanischen Schalter 22 in der ersten Phase 12. Die sternpunktbildende Schaltung 40 ist dabei auf einer lastzugewandten Seite der Hableiterschaltelemente 21, 23, 25 und der elektromechanischen Schalter 22, 24, 26 angebracht. Bei Vorliegen eines defekten Halbleiterschaltelements 21, 23, 25 und/oder eines defekten elektromechanischen Schalters 22, 24, 26 in der ersten Phase 12 liegt in dieser eine galvanische Verbindung 35 vor. Die galvanische Verbindung 35 ruft dabei über die sternpunktbildende Schaltung 40 einen Spannungsabfall 38 am Halbleiterschaltelement 21 und dem elektromechanischen Schalter 22 in der ersten Phase 12 hervor. In Abhängigkeit vom Ergebnis der Erfassung des Spannungsabfalls 38 verzweigt sich der Ablauf des Diagnoseverfahrens 100. Dies ist in FIG 2 durch die Verzweigung 125 abgebildet. Wenn im zweiten Verfahrensschritt 120 ein Spannungsabfall 38 erfasst wird, wird anhand dessen erkannt, dass das Halbleiterschaltelement 21 und der elektromechanische Schalter 22 in der ersten Phase 12 intakt sind. Dies stellt einen Endzustand 200 des Diagnoseverfahrens 100 dar. Wenn kein Spannungsabfall 38 erfasst wird, folgt ein dritter Verfahrensschritt 130. Im dritten Verfahrensschritt 130 wird eine Warnung ausgegeben und so ein Benutzer oder eine übergeordnete Steuereinheit informiert. Insbesondere werden im dritten Schritt 130 Gegenmaßnahmen eingeleitet, die ein Wiedereinschalten des Sanftstarters 10 vermeiden.

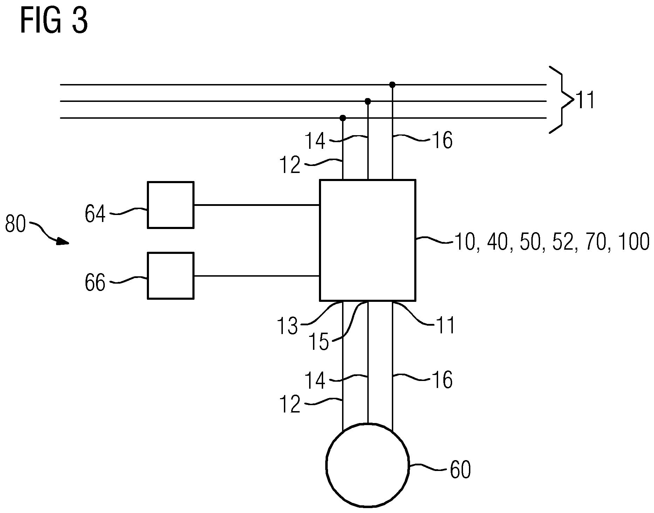

FIG 3 zeigt schematisch den Aufbau einer Ausführungsform einer Motoranordnung 80, die an eine mehrphasige Stromversorgung 11 angeschlossen ist. Die Motoranordnung 80 umfasst einen Elektromotor 60, der über eine erste, zweite und dritte Phase 12, 14, 16 mit Strom versorgt wird. Zwischen die Stromversorgung 11 und den Elektromotor 60 ist ein Sanftstarter 10 geschaltet, der über Anschlussklemmen 13, 15, 17 verfügt, an die der Elektromotor 60 angeschlossen ist. Der Sanftstarter 10 verfügt über eine nicht näher dargestellte sternpunktbildende Schaltung 40, wie beispielsweise in FIG 1 dargestellt. Der Sanftstarter 10 verfügt über eine Steuereinheit 50, die als eine interne Steuereinheit 52 ausgebildet ist. Die Steuereinheit 50 verfügt über einen Speicher und ein Rechenwerk und ist dazu ausgebildet, ein Computerprogrammprodukt 70 zu speichern. Das Computerprogrammprodukt 70 wird durch die Steuereinheit 50 ausgeführt und gewährleistet eine Diagnosefunktion für den Sanftstarter 10 gemäß dem Diagnoseverfahren 100. Der Sanftstarter 10 ist ferner mit einem Betriebsschalter 64 für das betriebsmäßige Betätigen des Elektromotors 60 ausgebildet ist. Der Betriebsschalter 64 ist dazu mit der Steuereinheit 50 gekoppelt. Ebenso ist ein sicherheitsgerichteter Schalter 66 mit dem Sanftstarter 10 verbunden, mit dem der Elektromotor 60 schnell und zuverlässig in einen sicheren Zustand gebracht werden kann. Dazu ist der sicherheitsgerichtete Schalter 66 als Not-Aus ausgebildet. Die Motoranordnung 80 gemäß FIG 3 weist durch die Diagnosefunktion im Sanftstarter 10 ein SIL-Level von 1 auf. Das Anbringen eines zusätzlichen Schützes ist entbehrlich. Folglich wird mit der Motoranordnung 80 nach FIG 3 bei reduziertem Hardwareaufwand ein verbessertes Sicherheitsniveau erreicht.

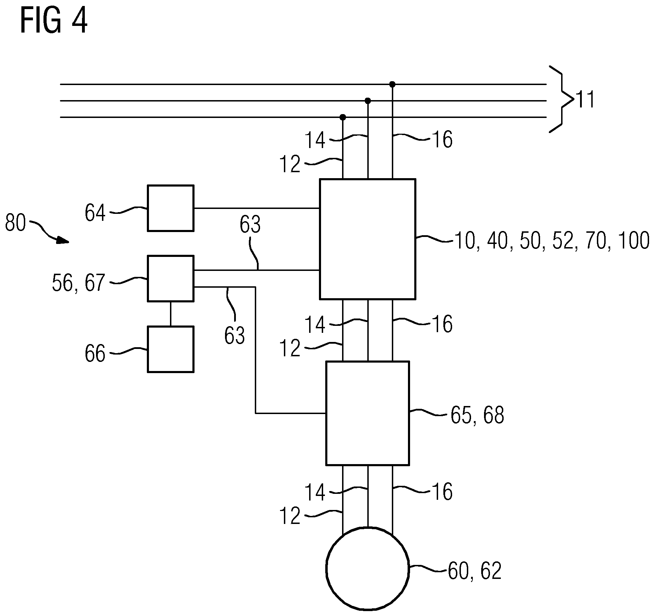

In FIG 4 ist schematisch der Aufbau der erfindungsgemäßen Ausführungsform einer Motoranordnung 80 dargestellt, die mit einer mehrphasigen Stromversorgung 11 verbunden ist. Die Motoranordnung 80 umfasst auch einen Elektromotor 60. Der Elektromotor 60 wird über drei Phasen 12, 14, 16 mit Strom versorgt. Ein Sanftstarter 10, wie in FIG 1 dargestellt, ist mit der Stromversorgung 11 verbunden. Dem Sanftstarter 10 ist wiederum ein als Schütz 65 ausgebildetes Schaltgerät 68 nachgeschaltet. Der Sanftstarter 10 ist mit einem Betriebsschalter 64 verbunden, über den das betriebsmäßige Betätigen des Elektromotors 60 erfolgt. Ferner ist der Sanftstarter 10 mit einem Sicherheitsschaltgerät 67 gekoppelt, das sowohl mit dem Sanftstarter 10 als auch dem Schaltgerät 68 jeweils über eine Kommunikationsverbindung 63 gekoppelt ist. Das Sicherheitsschaltgerät 68 ist dazu ausgebildet, den Zustand des Sanftstarters 10 durch Kommunikation mit der Steuereinheit 50 des Sanftstarters 10 zu erfassen und im Sinne einer übergeordneten Steuereinheit 56 Befehle an die Steuereinheit 50 des Sanftstarters 10 zu senden. Ebenso ist das Sicherheitsschaltgerät 68 mit dem Schaltgerät 68 derart gekoppelt, dass der Zustand des Schaltgeräts 68 erfassbar ist. Dazu verfügt das Schütz 65 über nicht näher dargestellte Meldekontakte. Das Sicherheitsschaltgerät 67 ist auch dazu ausgebildet, Befehle an das Schaltgerät 68 zu senden. Darüber hinaus ist das Sicherheitsschaltgerät 68 mit einem sicherheitsgerichteten Schalter 66 verbunden, der als Not-Aus ausgebildet ist. Durch den sicherheitsgerichteten Schalter 66 wird bei Bedarf, zum Beispiel in einem Notfall, schnell ein sicherer Zustand des Elektromotors 60 herbeigeführt.

Der Sanftstarter 10 verfügt über eine sternpunktbildende Schaltung 40, durch die in Verbindung mit der Steuereinheit 50, die als eine interne Steuereinheit 52 ausgebildet ist, Diagnoseverfahren 100 durchgeführt werden können, mit dem im Sanftstarter 10 defekte Komponenten, insbesondere defekte Halbleiterschaltelemente 21, 23, 25 und defekte elektromechanische Schalter 22, 24, 26, wie in FIG 1 dargestellt, selbsttätig identifizierbar sind. Dies erfolgt mittels eines Diagnoseverfahrens 100, das über ein Computerprogrammprodukt 70 umgesetzt wird, das in der Steuereinheit 40 ausführbar gespeichert ist.

Durch die Kombination aus dem erfindungsgemäßen Sanftstarter 10 mit einem Schaltgerät 68, hier also dem Schütz 65, wird in der Motoranordnung 80 nach FIG 4 ein SIL-Level von 3 erzielt. Der Sanftstarter 10 und das Schaltgerät 68 sind dabei zueinander diversitär. Die Motoranordnung 80 erreicht insgesamt ein Sicherheit-Integritäts-Level, kurz SIL, von 3. Im Gegensatz hierzu erfordern die aus dem Stand der Technik bekannten Lösungen mindestens zwei Schaltgeräte, insbesondere Schütze. Die erfindungsgemäße Motoranordnung bietet folglich ein hohes Maß an Sicherheit bei reduziertem Hardwareaufwand. Dadurch wird der Aufbau der erfindungsgemäßen Motoranordnung vereinfacht, beschleunigt und kosteneffizienter gestaltet.

## Patentansprüche

1. Motoranordnung (80) mit einem SIL-Level von 3, umfassend einen Elektromotor (60), der mit einem Schaltgerät (68), insbesondere einem Schütz (65), verbunden ist, dem ein Sanftstarter (10) vorgeschaltet ist, der mit einer Stromversorgung (11) gekoppelt ist, wobei der Sanftstarter (10) eine Mehrzahl an stromführenden Phasen (12, 14, 16) aufweist, wobei in jeder Phase (12, 14, 16) ein Halbleiterschaltelement (21, 23, 25) und ein dazu parallel geschalteter elektromechanischer Schalter (22, 24, 26) sowie ein Spannungsmessmittel (36) zur Erfassung eines über dem Halbleiterschaltelement (21, 23, 25) und dem zugehörigen elektromechanischen Schalter (22, 24, 26) auftretenden Spannungsabfalls (38) angeordnet ist,
wobei in dem Sanftstarter (10) auf der dem Elektromotor (60) zugewandten Seite (46) der Halbleiterschaltelemente (21, 23, 25) und der elektromechanischen Schalter (22, 24, 26) die Mehrzahl an Phasen (12, 14, 16) in einer sternpunktbildenden Schaltung (40) verbunden sind, die sternpunktbildende Schaltung (40) mindestens eine passive Komponente (43) umfasst und zur Erfassung eines über einem Halbleiterschaltelement (21, 23, 25) und einem dazu parallel geschalteten elektromechanischen Schalter (22, 24, 26) auftretenden Spannungsabfalls (38) in einem defekten Zustand des Halbleiterschaltelements (21, 23, 25) und/oder des elektromechanischen Schalters (22, 24, 26) ausgebildet ist.

2. Motoranordnung (80) nach Anspruch 1, wobei die mindestens eine passive Komponente (43) als Widerstand (44) mit 10 kΩ bis 500 kΩ ausgebildet ist.

3. Motoranordnung (80) nach Anspruch 1, wobei die mindestens eine passive Komponente (43) als Kondensator (47), insbesondere mit einer Kapazität von 4 nF bis 400 nF, ausgebildet ist.

4. Motoranordnung (80) nach einem der Ansprüche 1 bis 3, wobei der Sanftstarter (10) mit einer Steuereinheit (50) versehen ist, die als eine interne Steuereinheit (52) und/oder als eine übergeordnete Steuereinheit (56) ausgebildet ist.

5. Diagnoseverfahren (100) zur Erkennung eines defekten Halbleiterschaltelements (21, 23, 25) und/oder eines defekten elektromechanischen Schalters (22, 24, 26) in einem Sanftstarter (10) mit einer Mehrzahl an stromführenden Phasen (12, 14, 16), wobei der Sanftstarter (10) Bestandteil einer Motoranordnung (80) mit einem SIL-Level von 3 ist, die Motoranordnung (80) umfassend einen Elektromotor (60), der mit einem Schaltgerät (68), insbesondere einem Schütz (65), verbunden ist, dem der Sanftstarter (10) vorgeschaltet ist, der mit einer Stromversorgung (11) gekoppelt ist, das Diagnoseverfahren (100) umfassend die Schritte:
a) Ausgeben eines Betätigungsbefehls (55) zur Öffnung der Halbleiterschaltelemente (21, 23, 25) und der elektromechanischen Schalter (22, 24, 26);
b) Erfassen eines über einem Halbleiterschaltelement (21, 23, 25) und einem dazu parallel geschalteten elektromechanischen Schalter (22, 24, 26) auftretenden reduzierten Spannungsabfalls (38) in einer der stromführenden Phasen (12, 14, 16), die über eine in dem Sanftstarter (10) auf der dem Elektromotor (60) zugewandten Seite (46) der Halbleiterschaltelemente (21, 23, 25) und elektromechanischen Schalter (22, 24, 26) angeordnete sternpunktbildende Schaltung (40) mit den anderen stromführenden Phasen (12, 14, 16) verbunden ist;
c) Erkennen eines Defekts in einem der Halbleiterschaltelemente (21, 23, 25) oder einem der elektromechanischen Schalter (22, 24, 26), wenn im Schritt b) das Vorliegen des reduzierten Spannungsabfalls (38) erfasst wird, umfassend den weiteren, vor dem Schritt b) auszuführenden Schritt:
a1) Ausgeben eines Betätigungsbefehls (55) zur Öffnung von Kontakten des Schaltgeräts (68), über welche die stromführenden Phasen (12, 14, 16) geschaltet werden.

6. Diagnoseverfahren (100) nach Anspruch 5, wobei bei einem erkannten Defekt eine Warnung (49) ausgegeben wird und/oder mittels einer Steuereinheit (50) eine Betätigung zum Schließen der Halbleiterschaltelemente (21, 23, 25) und/oder der elektromechanischen Schalter (22, 24, 26) unterbunden wird.

7. Computerprogrammprodukt (70), derart ausgebildet, dass, wenn es in einer Steuereinheit (50) eines Sanftstarters (10) ausgeführt wird, die Motoranordnung (80) des Anspruchs 4, deren Steuereinheit (50) zum Empfangen von Messdaten (33) des Spannungsmessmittels (36), das mit einem Halbleiterschaltelement (21, 23, 25) und/oder elektromechanischen Schalter (22, 24, 26) des Sanftstarters (10) verbunden ist, und zum Ausgeben von Betätigungsbefehlen (55) an Halbleiterschaltelemente (21, 23, 25) und/oder elektromechanische Schalter (22, 24, 26) des Sanftstarters (10) ausgebildet ist, die Schritte des Diagnoseverfahrens (100) gemäß einem der Ansprüche 5 und 6 ausführt.

## Claims

1. Motor arrangement (80) with an SIL level of 3, comprising an electric motor (60) connected to a switching device (68), in particular a contactor (65), upstream of which is connected a soft starter (10) which is coupled to a power supply (11), wherein the soft starter (10) comprises a plurality of live phases (12, 14, 16), wherein, in each phase (12, 14, 16), a semiconductor switching element (21, 23, 25) and an electromechanical switch (22, 24, 26) connected in parallel therewith, as well as a voltage measuring means (36) for detecting a voltage drop (38) occurring across the semiconductor switching element (21, 23, 25) and the associated electromechanical switch (22, 24, 26), are arranged,
wherein, in the soft starter (10) on the side (46) of the semiconductor switching elements (21, 23, 25) and the electromechanical switches (22, 24, 26) facing the electric motor (60), the plurality of phases (12, 14, 16) are connected in a circuit (40) forming a star point, the circuit (40) forming a star point comprises at least one passive component (43) and is configured to detect a voltage drop (38) in a defective state of the semiconductor switching element (21, 23, 25) and/or the electromechanical switch (22, 24, 26) occurring across a semiconductor switching element (21, 23, 25) and an electromechanical switch (22, 24, 26) connected in parallel therewith.

2. Motor arrangement (80) according to Claim 1, wherein the at least one passive component (43) is configured as a resistor (44) with 10 kΩ to 500 kΩ.

3. Motor arrangement (80) according to Claim 1, wherein the at least one passive component (43) is configured as a capacitor (47), in particular with a capacitance of 4 nF to 400 nF.

4. Motor arrangement (80) according to any one of Claims 1 to 3, wherein the soft starter (10) is provided with a control unit (50), which is configured as an internal control unit (52) and/or as a higher-level control unit (56).

5. Diagnostic method (100) for detecting a defective semiconductor switching element (21, 23, 25) and/or a defective electromechanical switch (22, 24, 26) in a soft starter (10) with a plurality of live phases (12, 14, 16), wherein the soft starter (10) is an integral part of a motor arrangement (80) with an SIL level of 3, the motor arrangement (80) comprising an electric motor (60) connected to a switching device (68), in particular a contactor (65), upstream of which is connected the soft starter (10) which is coupled to a power supply (11), the diagnostic method (100) comprising the steps:
a) outputting an actuation command (55) for opening the semiconductor switching elements (21, 23, 25) and the electromechanical switches (22, 24, 26);
b) detecting a reduced voltage drop (38) occurring across a semiconductor switching element (21, 23, 25) and an electromechanical switch (22, 24, 26) connected in parallel therewith in one of the live phases (12, 14, 16), which is connected to the other live phases (12, 14, 16) via a circuit (40) forming a star point arranged in the soft starter (10) on the side (46) of the semiconductor switching elements (21, 23, 25) and the electromechanical switches (22, 24, 26) facing the electric motor (60);
c) detecting a defect in one of the semiconductor switching elements (21, 23, 25) or one of the electromechanical switches (22, 24, 26) if the presence of the reduced voltage drop (38) is detected in step b),
comprising the further step to be carried out before step b):
a1) outputting an actuation command (55) for opening contacts of the switching device (68), through which the live phases (12, 14, 16) are connected.

6. Diagnostic method (100) according to Claim 5, wherein a warning (49) is output in the case of a detected defect and/or an actuation for closing the semiconductor switching elements (21, 23, 25) and/or the electromechanical switches (22, 24, 26) is suppressed by means of a control unit (50).

7. Computer program product (70) designed such that, when it is executed in a control unit (50) of a soft starter (10), the motor arrangement (80) of Claim 4, the control unit (50) of which is configured to receive measurement data (33) from the voltage measuring means (36), which is connected to a semiconductor switching element (21, 23, 25) and/or electromechanical switch (22, 24, 26) of the soft starter (10), and to output actuation commands (55) to semiconductor switching elements (21, 23, 25) and/or electromechanical switches (22, 24, 26) of the soft starter (10), carries out the steps of the diagnostic method according to either of Claims 5 and 6.

## Revendications

1. Ensemble (80) moteur ayant un level -SIL de 3, comprenant un moteur (60) électrique qui est connecté à un appareil (68) de coupure, notamment à un contacteur (65), en amont duquel est monté un démarreur (10) progressif qui est connecté à une alimentation (11) en courant, le démarreur (10) progressif ayant une pluralité de phases (12, 14, 16) conduisant le courant dans lequel dans chaque phase (12, 14, 16) est monté un élément (21, 23, 25) de coupure à semi -conducteur et un interrupteur (22, 24, 26) électromécanique qui y est monté en parallèle ainsi qu'un moyen (36) de mesure de la tension pour relever une chute (38) de tension, se produisant aux bornes de l'élément (21, 23, 25) de coupure à semi -conducteur et de l 'interrupteur (22, 24, 26) électromécanique associé,
dans lequel dans le démarreur (10) progressif du côté (46), tourné vers le moteur (60 électrique, de l'élément (21, 23, 25) de coupure à semi -conducteur et de l'interrupteur (22, 24, 26) électromécanique, la pluralité de phases (12, 14, 16) sont reliées en un circuit (40) formant un point neutre, le circuit (40) formant un point neutre, comprenant au moins un composant (43) passif et étant constitué pour la détection d 'une chute (38) de tension se produisant aux bornes de l 'élément (21, 23, 25) de coupure à semi -conducteur et d'un interrupteur (22, 24, 26) électromécanique qui y est monté en parallèle dans un état défectueux de l'élément (21, 23, 25) de coupure à semi -conducteur et /ou de l'interrupteur (22, 24, 26) électro -mécanique.

2. Ensemble (80) moteur suivant la revendication 1, dans lequel le au moins un composant (43) passif est constitué sous la forme d'une résistance (44) de 10 kΩ à 500 kΩ.

3. Ensemble (80) moteur suivant la revendication 1, dans lequel le au moins un composant (43) passif est constitué sous la forme d'un condensateur (47) ayant notamment une capacité de 4 nF à 400 nF.

4. Ensemble (80) moteur suivant l'une des revendications 1 à 3, dans lequel le démarreur (10) progressif est pourvu d'une unité (50) de commande qui est constituée sous la forme d'une unité (52) de commande interne et /ou sous la forme d'une unité (56) de commande supérieure hiérarchiquement.

5. Procédé (100) de diagnostic pour détecter un élément (21, 23, 25) de coupure à semi -conducteur défectueux et /ou un interrupteur (22, 24, 26) électromécanique défectueux dans un démarreur (10) progressif ayant une pluralité de phases (12, 14, 16) conduisant le courant, le démarreur (10) progressif étant une partie constitutive d'un ensemble (80) moteur ayant un level -SIL de 3, l'ensemble (80) moteur comprenant un moteur (60) électrique qui est connecté à un appareil (68) de coupure, notamment à un contacteur (65), en amont duquel est monté le démarreur (10) progressif qui est connecté à une alimentation (11) en courant, le procédé (100) de diagnostic comprenant les stades :
a) émission d'une instruction (55) d'actionnement pour l 'ouverture des éléments (21, 23, 25) de coupure à semi-conducteur et des interrupteurs (22, 24, 26) électromécaniques;
b) relevé d'unechute (38) de tension réduite se produisant aux bornes d'un élément (21, 23, 25) de coupure à semi - conducteur et d'un interrupteur (22, 24, 26) électromécanique qui est monté en parallèle dans l'une des phases (12, 14, 16) conduisant le courant, qui est reliée aux autres phases (12, 14, 16) conduisant le courant par l'intermédiaire d'un circuit (40) formant un point neutre, monté dans le démarreur (10) progressif du côté (46), tourné vers le moteur (60) électrique, des éléments (21, 23, 25) de coupure à semi - conducteur et des interrupteurs (22, 24, 26) électromécaniques,
c) détection d'un défaut dans l'un des éléments (21, 23, 25) de coupure à semi -conducteur ou dans l'un des interrupteurs (22, 24, 26) électromécaniques si au stade b) on relève la présence de la chute (38) de tension réduite,
comprenant l'autre stade à effectuer avant le stade b) :
a1) émission d'une instruction (55) d 'actionnement pour l 'ouverture de contacts de l'appareil (68) de coupure, par laquelle les phases (12, 14, 16) conduisant le courant sont mises en circuit.

6. Procédé (100) de diagnostic suivant la revendication 5, dans lequel, lorsqu'un défaut est détecté, on émet un avertissement (49) et /ou, au moyen d'une unité (50) de commande, on supprime un actionnement pour la fermeture des éléments (21, 23, 25) de coupure à semi -conducteur et /ou des interrupteurs (22, 24, 26) électromécaniques.

7. Produit (70) de programme d'ordinateur, qui est constitué de manière à ce que lorsqu'il est réalisé dans une unité (50) de commande d'un démarreur (10) progressif, l'ensemble (80) moteur de la revendication 4, dont l'unité (50) de commandes est, pour la réception de données (33) de mesure du moyen (36) de mesure de tension, qui est connecté à un élément (21, 23, 25) de coupure à semi -conducteur et /ou à un interrupteur (22, 24, 26) électromécanique du démarreur (10) progressif, constituée pour l'émission d'instructions (55) d 'actionnement d'éléments (21, 23, 25) de coupure à semi-conducteur et /ou d'interrupteurs (22, 24, 26) électromécaniques du démarreur (10) progressif, pour effectuer les stades du procédé (100) de diagnostic suivant l'une des revendications 5 et 6.
